# EUROPEAN PATENT APPLICATION

(11) **EP 4 768 949 A1**
(43) Date of publication of application: **01.07.2026**
(21) Application number: 24874907.9
(22) Date of filing: 26.09.2024
(51) Int. Cl.: G01R 31/385, G01R 31/389, G01R 31/374, G01R 27/08, G01R 31/3842

(54) **BATTERY DIAGNOSIS DEVICE AND OPERATING METHOD THEREOF**

(30) Priority: 06.10.2023 KR 20230133745
(71) Applicant: LG Energy Solution, Ltd., Seoul 07335 (KR)
(72) Inventor: SUNG, Jin Su, Daejeon 34122 (KR); KIM, Ki Woong, Daejeon 34122 (KR); AN, In Gu, Daejeon 34122 (KR); KIM, Hye Jin, Daejeon 34122 (KR); OH, Yun Pyo, Daejeon 34122 (KR); KIM, Min Hyun, Daejeon 34122 (KR)
(74) Representative: BCKIP Part mbB
(86) International application number: PCT/KR2024/014612
(87) International publication number: WO 2025/075349

(57) **Abstract**

A battery diagnosis apparatus according to an embodiment disclosed herein includes an information obtaining unit configured to measure a current and a voltage of each of a plurality of battery cells, a resistance measuring unit configured to measure a cell resistance of the plurality of battery cells based on a discharging current and a discharging voltage of each of the plurality of battery cells, and a controller configured to apply a preset charging current to each of the plurality of battery cells for a preset charging time before resistance measurement of the resistance measuring unit and determine an assembly state of each of the plurality of battery cells based on the cell resistance.

## Description

### TECHNICAL FIELD

### CROSS-REFERENCE TO RELATED APPLICATION

This application claims priority to and the benefit of Korean Patent Application No. 10-2023-0133745 filed in the Korean Intellectual Property Office on October 6, 2023, the entire content of which is incorporated herein by reference.

### TECHNICAL FIELD

Embodiments disclosed herein relate to a battery diagnosis apparatus and an operating method thereof.

### BACKGROUND ART

Recently, demands for portable electronic products such as laptops, video cameras, portable phones, etc., have increased rapidly, and as the development of electric vehicles, energy storage batteries, robots, satellites, etc., is rapidly advancing, research on high-performance secondary batteries that may be repeatedly charged and discharged has been actively pursued.

Current commercial secondary batteries include nickel cadmium batteries, nickel hydrogen batteries, nickel zinc batteries, lithium secondary batteries, etc. Among these batteries, lithium secondary batteries have been highlighted because they are charged and discharged freely with a little memory effect compared to nickel-based secondary batteries, and also have very low self-discharge rate and high energy density.

Meanwhile, among such secondary batteries, a resistance of a lithium iron phosphate (LFP) battery increases according to self-discharging during a storage period after cell manufacturing. That is, when a long time of period is required until pack assembly after cell manufacturing, a state of charge (SOC) decreases and a cell resistance increases according to self-discharging of a cell. An assembly state of a plurality of battery cells included in a battery pack is determined by measuring a resistance of each cell, and a resistance increase due to self-discharging and a resistance increase due to an assembly defect are not distinguished from each other, resulting in a decrease in the accuracy of assembly defect determination and degradation of efficiency.

### DISCLOSURE

### TECHNICAL PROBLEM

Embodiments disclosed herein aim to provide a battery diagnosis apparatus and an operating method thereof in which an assembly state of a battery cell may be determined.

Embodiments disclosed herein aim to provide a battery diagnosis apparatus and an operating method thereof in which the accuracy of assembly state determination of a battery cell may be improved by compensating for a resistance increase of the battery cell.

Technical problems of the embodiments disclosed herein are not limited to the aforementioned technical problems, and other unmentioned technical problems would be clearly understood by those of ordinary skill in the art from the following description.

### TECHNICAL SOLUTION

A battery diagnosis apparatus according to an embodiment disclosed herein includes an information obtaining unit configured to measure a current and a voltage of each of a plurality of battery cells, a resistance measuring unit configured to measure a cell resistance of the plurality of battery cells based on a discharging current and a discharging voltage of each of the plurality of battery cells, and a controller configured to apply a preset charging current to each of the plurality of battery cells for a preset charging time before resistance measurement of the resistance measuring unit and determine an assembly state of each of the plurality of battery cells based on the cell resistance.

According to an embodiment, the information obtaining unit may be further configured to obtain a manufacturing date of each of the plurality of battery cells, and the controller may be further configured to determine whether the manufacturing date of each of the plurality of battery cells precedes a reference date and select a compensation battery cell from among the plurality of battery cells, based on a determination result.

According to an embodiment, the controller may be further configured to apply the charging current to the compensation battery cell.

According to an embodiment, the information obtaining unit may be further configured to obtain a state of charge (SOC) of each of the plurality of battery cells, and the controller may be further configured to determine whether an SOC of each of the plurality of battery cells is less than a reference SOC and select a compensation battery cell from among the plurality of battery cells, based on a determination result.

According to an embodiment, the controller may be further configured to adjust a magnitude of the charging current to be more than twice a magnitude of the discharging current.

According to an embodiment, the controller may be further configured to maintain a current of each of the plurality of battery cells in a preset range between the charging time and the resistance measurement of the resistance measuring unit.

According to an embodiment, the resistance measuring unit may be further configured to measure a cell resistance of each of the plurality of battery cells by discharging each of the plurality of battery cells for a preset discharging time, and the controller may be further configured to adjust the preset charging time to be longer than the preset discharging time.

According to an embodiment, the resistance measuring unit may be further configured to measure the cell resistance of each of the plurality of battery cells by using a direct current internal resistance (DCIR) scheme.

According to an embodiment, the controller may be further configured to determine, as being defective, an assembly state of a battery cell having a cell resistance greater than or equal to a preset resistance from among the plurality of battery cells.

A battery diagnosis method according to an embodiment disclosed herein includes applying a preset charging current to each of a plurality of battery cells for a preset charging time, measuring a cell resistance of the plurality of battery cells based on a discharging current and a discharging voltage of each of the plurality of battery cells, and determining an assembly state of each of the plurality of battery cells based on the cell resistance.

According to an embodiment. the battery diagnosis method may further include obtaining a manufacturing date or state of charge (SOC) of each of the plurality of battery cells and selecting a compensation battery cell from among the plurality of battery cells based on at least one of the manufacturing date or the SOC.

According to an embodiment, a magnitude of the charging current may be greater than or equal to twice a magnitude of the discharging current.

According to an embodiment, the measuring of the cell resistance may include measuring a cell resistance of each of the plurality of battery cells by discharging each of the plurality of battery cells for a preset discharging time, and the preset charging time may be longer than the preset discharging time.

According to an embodiment, the measuring of the cell resistance may include measuring the cell resistance of each of the plurality of battery cells by using a direct current internal resistance (DCIR) scheme.

According to an embodiment, the determining of the assembly state may include determining, as being defective, an assembly state of a battery cell having a cell resistance greater than or equal to a preset resistance from among the plurality of battery cells.

Specific details of other embodiments are included in the detailed description and drawings.

### ADVANTAGEOUS EFFECTS

A battery diagnosis apparatus and an operating method thereof according to embodiments disclosed herein may determine an assembly state of a battery cell.

The battery diagnosis apparatus and the operating method according to embodiments disclosed herein may improve the accuracy of assembly state determination of a battery cell by compensating for a resistance increase of the battery cell.

The technical effects of the battery diagnosis apparatus and the operating method thereof according to embodiments disclosed in the present document are not limited to the effects mentioned above, and other effects not mentioned will be clearly understood by those of ordinary skill in the art according to the disclosure of the present document.

### DESCRIPTION OF DRAWINGS

FIG. 1 is a block diagram of a battery pack according to an embodiment disclosed herein.
FIG. 2 is a block diagram of a battery diagnosis apparatus according to an embodiment disclosed herein.
FIG. 3 is a view showing an operation, performed by a battery diagnosis apparatus according to an embodiment disclosed herein, of compensating for a resistance increase of a battery cell.
FIG. 4 is a flowchart showing a battery diagnosis method according to an embodiment disclosed herein.
FIG. 5 is a block diagram showing a computing system that performs a battery diagnosis method according to an embodiment disclosed herein.

With regard to the description of the drawings, identical reference numerals may be used to refer to identical or related elements.

### MODE FOR INVENTION

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. In the case of online distribution, at least a part of a computer program product may be at least temporarily stored in a machine-readable storage medium such as a memory of a server of a manufacturer, a server of an application store, or a relay server, or may be generated temporarily. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

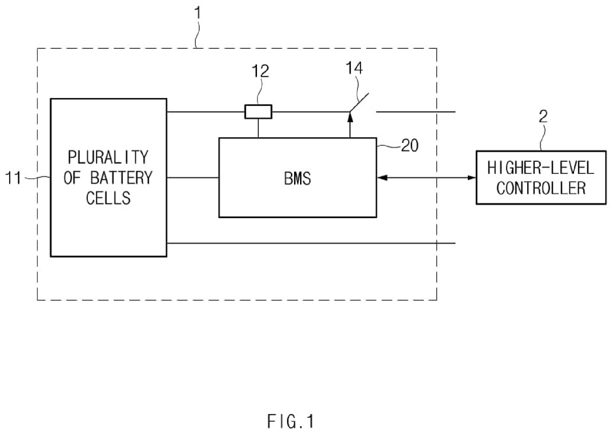

FIG. 1 is a block diagram of a battery pack according to an embodiment disclosed herein.

Referring to FIG. 1, a battery control system including a battery pack 1 and a higher-level controller 2 included in a higher-level system, according to an embodiment of the present disclosure is schematically shown.

As shown in FIG. 1, the battery pack 1 may include one or more battery cells 11, a switching unit 14 serially connected to a first terminal side and/or a second terminal side of the battery cell 11 to control a charging or discharging current flow of the battery cell 11, and a battery management system 20 that performs management to prevent over-charging, over-discharging, etc., by monitoring voltage, current, temperature, etc., of the battery pack 1.

In this case, the battery pack 1 may include the battery cell 11, a sensor 12, the switching unit 14, and the battery management system 20 provided in plural. For example, the first terminal may be a positive (+) terminal of the battery cell 11, and the second terminal may be a negative (-) terminal.

Herein, as the switching unit 14 which is an element for controlling a current flow for charging or discharging of the plurality of battery cells 11, for example, at least one relay, magnetic contactor, etc., may be used according to specifications of the battery pack 1.

The battery management system 20, which is an interface for receiving measurement values of the above-described various parameter values, may include a plurality of terminals and a circuit, etc., connected thereto to process input values. The battery management system 20 may also control on/off of the switching unit 14, e.g., a relay, a contactor, etc., and may be connected to the battery cell 11 to monitor the state of each battery cell 11.

The higher-level controller 2 may transmit a control signal regarding the battery cell 11 to the battery management system 20. Thus, the battery management system 20 may also be controlled in terms of an operation thereof based on a signal applied from the higher-level controller 2.

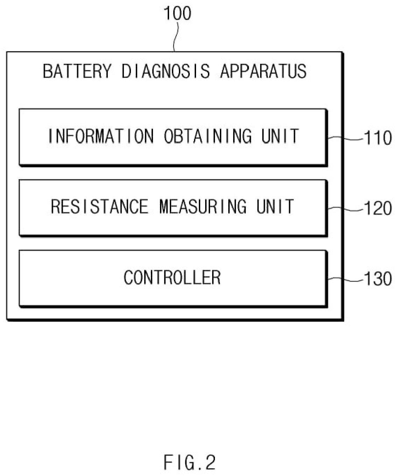

According to an embodiment, the battery management system 20 may include a battery diagnosis apparatus 100 of FIG. 2. According to another embodiment, the battery management system 20 may be different from the battery diagnosis apparatus 100 of FIG. 2. That is, the battery diagnosis apparatus 100 of FIG. 2 may be included in the battery pack 1 and may be configured as another device outside the battery pack 1.

Hereinbelow, for convenience of description, it is assumed that the battery diagnosis apparatus 100 includes another device outside the battery pack 1, without being limited thereto. For example, the following operation of the battery diagnosis apparatus 100 may also be performed in various devices such as not only a battery management system (BMS) in a vehicle, but also a server, a cloud, a charger, a charger/discharger, etc.

FIG. 2 is a block diagram of a battery diagnosis apparatus according to an embodiment disclosed herein.

Referring to FIG. 2, the battery diagnosis apparatus 100 may include an information obtaining unit 110, a resistance measuring unit 120, and a controller 130. The battery diagnosis apparatus 100 may determine an assembly state of a battery cell through the information obtaining unit 110, the resistance measuring unit 120, and the controller 130. That is, the battery diagnosis apparatus 100 may diagnose a state in which each of the plurality of battery cells 11 included in the battery pack is assembled to the battery pack.

The information obtaining unit 110 may obtain information of the battery cell. The information obtaining unit 110 may obtain information of each of the plurality of battery cells 11 included in the battery pack. According to an embodiment, the data obtaining unit 110 may obtain information about a current and a voltage of each of the plurality of battery cells 11. The information obtaining unit 110 may measure, but not limited to, the current or voltage of each of the plurality of battery cells 11. For example, the information obtaining unit 110 may not measure the voltage or the current and may receive the information about the voltage or the current of each of the plurality of battery cells 11 from a separate device or a server.

According to an embodiment, the information obtaining unit 110 may obtain manufacturing date information. That is, the information obtaining unit 110 may obtain the manufacturing date information of each of the plurality of battery cells 11. For example, the information obtaining unit 110 may obtain the manufacturing date information by receiving the manufacturing date information corresponding to each of the plurality of battery cells 11 from a separate storing unit or a server.

According to an embodiment, the information obtaining unit 110 may obtain SOC information. That is, the information obtaining unit 110 may obtain the SOC information of each of the plurality of battery cells 11. For example, the information obtaining unit 110 may directly measure SOC of each of the plurality of battery cells 11 or receive the SOC information corresponding to each of the plurality of battery cells 11 from a separate storing unit or a server.

The resistance measuring unit 120 may measure a cell resistance of a battery cell. The resistance measuring unit 120 may measure a cell resistance of each of the plurality of battery cells 11 included in the battery pack.

According to an embodiment, the resistance measuring unit 120 may measure a cell resistance by using a direct current internal resistance (DCIR) scheme. In this case, the resistance measuring unit 120 may discharge each of the plurality of battery cells 11 to a preset discharging current to measure a voltage drop, and measure the cell resistance of each of the plurality of battery cells 11 based on a discharging current value and a voltage drop value. That is, the resistance measuring unit 120 may discharge each of the plurality of battery cells 11 for a discharging time based on the discharging current and a discharging voltage, thereby measuring the cell resistance of each of the plurality of battery cells 11.

The controller 130 may apply a charging current to a battery cell. The controller 130 may directly apply a charging current to each of the plurality of battery cells 11 or control a separately provided charger, etc., to apply the charging current to each of the plurality of battery cells 11.

According to an embodiment, the controller 130 may apply the charging current before cell resistance measurement of the resistance measuring unit 120. That is, after the controller 130 applies the charging current to each of the plurality of battery cells 11, the resistance measuring unit 120 may measure the cell resistance of each of the plurality of battery cells 11. That is, charging current application of the controller 130 and cell resistance measurement of the resistance measuring unit 120 may constitute one set, and the cell resistance measurement of the resistance measuring unit 120 may be performed after the charging current application of the controller 130.

The controller 130 may adjust a magnitude of the charging current. According to an embodiment, the controller 130 may adjust the magnitude of the charging current to more than twice the magnitude of the discharging current. That is, the controller 130 may set the magnitude of the charging current applied to each of the plurality of battery cells 11 to a specific value. For example, the controller 130 may set the magnitude of the charging current to, but not limited to, 2 C-rate.

The controller 130 may adjust a charging time. According to an embodiment, the controller 130 may adjust the charging time longer than a discharging time of the resistance measuring unit 120. That is, the controller 130 may adjust a length of the charging time for which the charging current is applied to each of the plurality of battery cells 11 to be longer than the discharging time for which the resistance measuring unit 120 discharges each of the plurality of battery cells 11.

The controller 130 may set a rest time. The controller 130 may set the rest time between the charging time and the discharging time. Herein, the rest time may be defined as a time between the charging time and the discharging time. When a diagnosis time of each of the plurality of battery cells 11 is fixed, a length of the rest time may be a time obtained by subtracting the charging time and the discharging time from a total time.

The controller 130 may maintain a current of each of the plurality of battery cells 11 in a preset range in the rest time. For example, the controller 130 may maintain a current of each of the plurality of battery cells 11 as 0 for the rest time.

According to an embodiment, the controller 130 may select a compensation battery cell. The controller 130 may select the compensation battery cell from among the plurality of battery cells 11 included in the battery pack.

According to an embodiment, the controller 130 may select the compensation battery cell based on a manufacturing date. The controller 130 may determine whether the manufacturing date of each of the plurality of battery cells 11 precedes a reference date and select the compensation battery cell based on a determination result. For example, the controller 130 may extract battery cells having manufacturing dates previous to the reference date from among the plurality of battery cells 11 and select the extracted battery cells as compensation battery cells. That is, the controller 130 may select, as compensation battery cells, battery cells having manufacturing dates from which a predetermined time has elapsed.

According to an embodiment, the controller 130 may select a compensation battery cell based on SOC. The controller 130 may determine whether the SOC of each of the plurality of battery cells 11 is less than reference SOC and select the compensation battery cell based on a determination result. For example, the controller 130 may extract battery cells having SOC less than the reference SOC previous to the reference date from among the plurality of battery cells 11 and select the extracted battery cells as compensation battery cells. That is, the controller 130 may select, as compensation battery cells, battery cells having SOC decreasing according to storage of the battery cells.

According to an embodiment, the controller 130 may charge the compensation battery cells by applying current to the compensation battery cells. That is, the controller 130 may apply the charging current to the compensation battery cells selected from among the plurality of battery cells 11.

The controller 130 may determine an assembly state. The controller 130 may determine an assembly state of the plurality of battery cells 11 included in the battery pack. According to an embodiment, the controller 130 may determine the assembly state of each of the plurality of battery cells 11 based on the cell resistance of each of the plurality of battery cells 11. For example, the controller 130 may determine, as being defective, an assembly state of the battery cell 11 having a cell resistance greater than or equal to a preset resistance. The controller 130 may determine, as being normal, an assembly state of the battery cell 11 having a cell resistance less than the preset resistance. Herein, the preset resistance may be set based on a type of a battery cell, a type of a battery pack, etc.

According to an embodiment, the battery diagnosis apparatus 100 may provide assembly state information to a user. For example, the battery diagnosis apparatus 100 may provide assembly state information of a battery cell to a user terminal, a personal computer (PC), etc., through a communication unit (not shown) and also provide the assembly state information of the battery cell through a display included in a vehicle, a charger, etc.

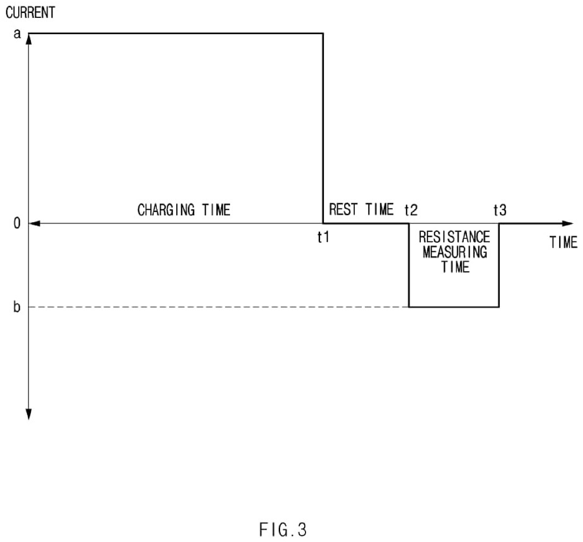

FIG. 3 is a view showing an operation, performed by a battery diagnosis apparatus according to an embodiment disclosed herein, of compensating for a resistance increase of a battery cell.

Referring to FIG. 3, the battery diagnosis apparatus 100 may determine the assembly state of each of the plurality of battery cells 11. The battery diagnosis apparatus 100 may measure the cell resistance of each of the plurality of battery cells 11 based on a charging operation, a rest operation, and a resistance measuring operation, and determine the assembly state based on the cell resistance.

A charging current applied by the controller 130 to each of the plurality of battery cells 11 may be a[A], and a discharging current discharged by the resistance measuring unit 120 may be b[A]. According to an embodiment, the controller 130 may adjust the magnitude of the charging current, a, to be greater than the magnitude of the discharging current, b. That is, a may be greater than b. According to an embodiment, the controller 130 may adjust the magnitude of the charging current, a, to be greater than twice the magnitude of the discharging current, 2b.

A time for which the controller 130 applies the charging current to each of the plurality of battery cells 11 may be t1, and a resistance measuring time for which the resistance measuring unit 120 discharges each of the plurality of battery cells 11 may be (t3 - t2). The controller 130 may adjust the charging time t1 to be longer than the resistance measuring time (t3 - t2). That is, a time for which the controller 130 applies the charging current may be longer than a time for which the resistance measuring unit 120 measures a resistance through discharging.

The rest time may be arranged between the charging time and the resistance measuring time. That is, the rest time may be a time from t1 at which the charging time ends to t2 at which the resistance measuring time starts. The controller 130 may maintain a current of the plurality of battery cells 11 in a preset range for the rest time.

The battery diagnosis apparatus 100 may determine the assembly state of the battery cell. The battery diagnosis apparatus 100 may determine the assembly state of the battery cell based on the cell resistance of the battery cell.

The battery diagnosis apparatus 100 may improve the accuracy of assembly state determination of the battery cell by compensating for a resistance increase of the battery cell through application of the charging current.

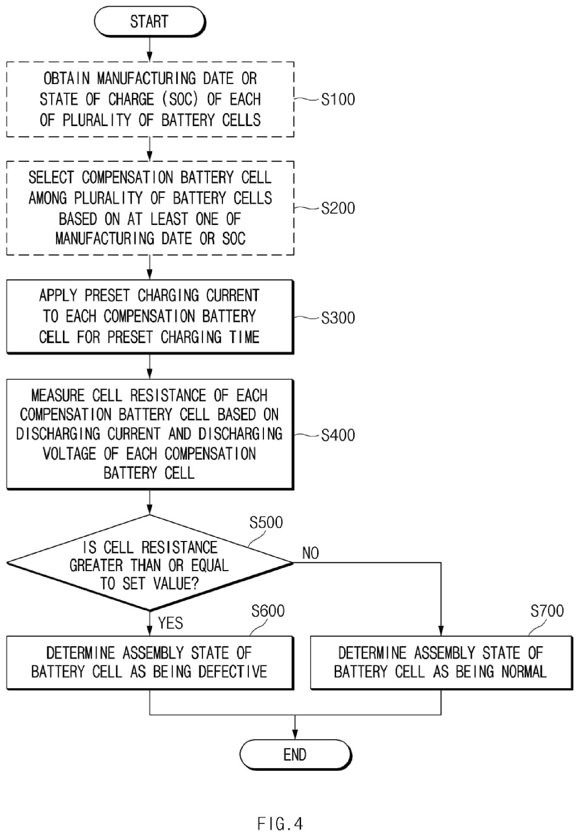

FIG. 4 is a flowchart showing a battery diagnosis method according to an embodiment disclosed herein.

An embodiment shown in FIG. 4 is merely an embodiment, and an order of operations according to various embodiments of the present disclosure may be different from that shown in FIG. 4, some operations shown in FIG. 4 may be omitted, or an order of the operations may be changed or operations may be merged.

Referring to FIG. 4, a battery diagnosis method may include operation S100 of obtaining a manufacturing date or SOC of each of a plurality of battery cells, operation S200 of selecting a compensation battery cell from among the plurality of battery cells based on at least one of the manufacturing date or the SOC, operation S300 of applying a preset charging current to each compensation battery cell for a preset charging time, operation S400 of measuring a cell resistance of each compensation battery cell based on a discharging current and a discharging voltage of each compensation battery cell, operation S500 of determining whether the cell resistance is greater than or equal to a set value, operation S600 of determining an assembly state of the battery cell as being defective, and operation S700 of determining the assembly state of the battery cell as being normal.

Hereinbelow, operation S100 to S700 will be described in detail with reference to FIGS. 1 to 4.

In operation S100, the battery diagnosis apparatus 100 may obtain a manufacturing date or SOC of each of the plurality of battery cells 11.

According to an embodiment, the battery diagnosis apparatus 100 may obtain manufacturing date information. That is, the battery diagnosis apparatus 100 may obtain the manufacturing date information of each of the plurality of battery cells 11. For example, the battery diagnosis apparatus 100 may obtain the manufacturing date information by receiving the manufacturing date information corresponding to each of the plurality of battery cells 11 from a separate storing unit or a server.

According to an embodiment, the battery diagnosis apparatus 100 may obtain SOC information. That is, the battery diagnosis apparatus 100 may obtain the SOC information of each of the plurality of battery cells 11. For example, the battery diagnosis apparatus 100 may directly measure SOC of each of the plurality of battery cells 11 or receive the SOC information corresponding to each of the plurality of battery cells 11 from a separate storing unit or a server.

In operation S200, the battery diagnosis apparatus 100 may select a compensation battery cell from among the plurality of battery cells 11 based on at least one of the manufacturing date or the SOC.

According to an embodiment, the battery diagnosis apparatus 100 may select a compensation battery cell. The battery diagnosis apparatus 100 may select the compensation battery cell from among the plurality of battery cells 11 included in the battery pack.

According to an embodiment, the battery diagnosis apparatus 100 may select the compensation battery cell based on a manufacturing date. The battery diagnosis apparatus 100 may determine whether the manufacturing date of each of the plurality of battery cells 11 precedes a reference date and select the compensation battery cell based on a determination result. For example, the battery diagnosis apparatus 100 may extract battery cells having manufacturing dates previous to the reference date from among the plurality of battery cells 11 and select the extracted battery cells as compensation battery cells. That is, the battery diagnosis apparatus 100 may select, as compensation battery cells, battery cells having manufacturing dates from which a predetermined time has elapsed.

According to an embodiment, the battery diagnosis apparatus 100 may select the compensation battery cell based on the SOC. The battery diagnosis apparatus 100 may determine whether the SOC of each of the plurality of battery cells 11 is less than reference SOC and select the compensation battery cell based on a determination result. For example, the battery diagnosis apparatus 100 may extract battery cells having SOC less than the reference SOC previous to the reference date from among the plurality of battery cells 11 and select the extracted battery cells as compensation battery cells. That is, the battery diagnosis apparatus 100 may select, as compensation battery cells, battery cells having SOC decreasing according to storage of the battery cells.

According to an embodiment, operations S100 and S200 may be omitted. In this case, the battery diagnosis apparatus 100 may perform operation S300 on all battery cells included in a battery pack, without selecting a compensation battery cell. Hereinbelow, for convenience of a description, the description will be made assuming that the battery diagnosis method includes operations S100 and S200.

In operation S300, the battery diagnosis apparatus 100 may apply a preset charging current to each compensation battery cell for a preset charging time.

The battery diagnosis apparatus 100 may apply the charging current to the compensation battery cell. The battery diagnosis apparatus 100 may directly apply the charging current to each of a plurality of compensation battery cells or control a separately provided charger, etc., to apply the charging current to each of the plurality of compensation battery cells.

In operation S400, the battery diagnosis apparatus 100 may measure a cell resistance of each compensation battery cell based on a discharging current and a discharging voltage of each compensation battery cell.

The battery diagnosis apparatus 100 may measure the cell resistance of the battery cell. The battery diagnosis apparatus 100 may measure a cell resistance of each of the plurality of battery cells 11 included in the battery pack.

According to an embodiment, the battery diagnosis apparatus 100 may measure a cell resistance by using a DCIR scheme. In this case, the battery diagnosis apparatus 100 may discharge each of the plurality of battery cells 11 to a preset discharging current to measure a voltage drop, and measure the cell resistance of each of the plurality of battery cells 11 based on a discharging current value and a voltage drop value. That is, the battery diagnosis apparatus 100 may discharge each of the plurality of battery cells 11 for a discharging time based on the discharging current and a discharging voltage, thereby measuring the cell resistance of each of the plurality of battery cells 11.

In operation S500, the battery diagnosis apparatus 100 may determine whether the cell resistance is greater than or equal to a set value. When the cell resistance is greater than or equal to the set value, operation S600 may be performed. When the cell resistance is less than the set value, operation S700 may be performed.

In operation S600, the battery diagnosis apparatus 100 may determine the assembly state of the battery cell as being defective. For example, the battery diagnosis apparatus 100 may determine, as being defective, the assembly state of the battery cell having a cell resistance greater than or equal to a preset resistance among the plurality of battery cells 11.

In operation S700, the battery diagnosis apparatus 100 may determine the assembly state of the battery cell as being normal. For example, the battery diagnosis apparatus 100 may determine, as being normal, the assembly state of the battery cell having a cell resistance less than the preset resistance among the plurality of battery cells 11.

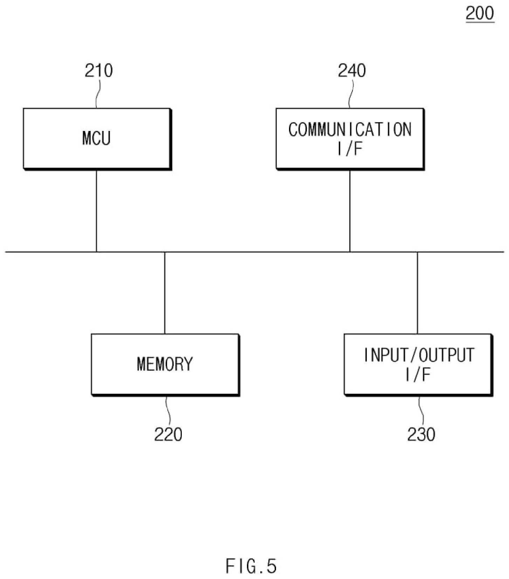

FIG. 5 is a block diagram showing a computing system that performs a battery diagnosis method according to an embodiment disclosed herein.

Referring to FIG. 5, a computing device 200 according to an embodiment disclosed herein may include a microcontroller unit (MCU) 210, a memory 220, an input/output interface (I/F) 230, and a communication I/F 240.

The MCU 210 may be a processor that executes various programs (e.g., an SOH calculation program, a cell balancing target determination program, etc.) stored in the memory 220, processes various data including an SOC, an SOH, etc., of the plurality of battery cells through these programs, and executes the above-described functions of the battery diagnosis apparatus 100 described with reference to FIGS. 1 to 3.

The memory 220 may store various programs regarding SOH calculation of the battery cell, cell balancing target determination, etc. Moreover, the memory 220 may store various data such as SOC data, SOH data, etc., of each battery cell.

The memory 220 may be provided in plural, depending on a need. The memory 220 may be a volatile or nonvolatile memory. For the memory 220 as the volatile memory, random access memory (RAM), dynamic RAM (DRAM), static RAM (SRAM), etc., may be used. For the memory 220 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., with the MCU 210.

The communication I/F 240, which is a component capable of transmitting and receiving various data to and from a server, may be various devices capable of supporting wired or wireless communication. For example, a program for SOH calculation of the battery cell or balancing target determination or various data, etc., may be transmitted and received to and from a separately provided external server through the communication I/F 240.

As such, the battery diagnosis method according to an embodiment disclosed herein may be recorded in the memory 220 and executed by the MCU 210.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

## Claims

1. A battery diagnosis apparatus comprising:
an information obtaining unit configured to measure a current and a voltage of each of a plurality of battery cells;
a resistance measuring unit configured to measure a cell resistance of the plurality of battery cells based on a discharging current and a discharging voltage of each of the plurality of battery cells; and
a controller configured to:
apply a preset charging current to each of the plurality of battery cells for a preset charging time before resistance measurement of the resistance measuring unit; and
determine an assembly state of each of the plurality of battery cells based on the cell resistance.

2. The battery diagnosis apparatus of claim 1, wherein the information obtaining unit is further configured to obtain a manufacturing date of each of the plurality of battery cells, and
the controller is further configured to:
determine whether the manufacturing date of each of the plurality of battery cells precedes a reference date; and
select a compensation battery cell from among the plurality of battery cells, based on a determination result.

3. The battery diagnosis apparatus of claim 2, wherein the controller is further configured to apply the charging current to the compensation battery cell.

4. The battery diagnosis apparatus of claim 1, wherein the information obtaining unit is further configured to obtain a state of charge (SOC) of each of the plurality of battery cells, and
the controller is further configured to:
determine whether an SOC of each of the plurality of battery cells is less than a reference SOC; and
select a compensation battery cell from among the plurality of battery cells, based on a determination result.

5. The battery diagnosis apparatus of claim 1, wherein the controller is further configured to adjust a magnitude of the charging current to be more than twice a magnitude of the discharging current.

6. The battery diagnosis apparatus of claim 1, wherein the controller is further configured to maintain a current of each of the plurality of battery cells in a preset range between the charging time and the resistance measurement of the resistance measuring unit.

7. The battery diagnosis apparatus of claim 1, wherein the resistance measuring unit is further configured to measure a cell resistance of each of the plurality of battery cells by discharging each of the plurality of battery cells for a preset discharging time, and
the controller is further configured to adjust the preset charging time to be longer than the preset discharging time.

8. The battery diagnosis apparatus of claim 1, wherein the resistance measuring unit is further configured to measure the cell resistance of each of the plurality of battery cells by using a direct current internal resistance (DCIR) scheme.

9. The battery diagnosis apparatus of claim 1, wherein the controller is further configured to determine, as being defective, an assembly state of a battery cell having a cell resistance greater than or equal to a preset resistance from among the plurality of battery cells.

10. A battery diagnosis method comprising:
applying a preset charging current to each of a plurality of battery cells for a preset charging time;
measuring a cell resistance of the plurality of battery cells based on a discharging current and a discharging voltage of each of the plurality of battery cells; and
determining an assembly state of each of the plurality of battery cells based on the cell resistance.

11. The battery diagnosis method of claim 10, further comprising:
obtaining a manufacturing date or state of charge (SOC) of each of the plurality of battery cells; and
selecting a compensation battery cell from among the plurality of battery cells based on at least one of the manufacturing date or the SOC.

12. The battery diagnosis method of claim 10, wherein a magnitude of the charging current is greater than or equal to twice a magnitude of the discharging current.

13. The battery diagnosis method of claim 10, wherein the measuring of the cell resistance comprises measuring a cell resistance of each of the plurality of battery cells by discharging each of the plurality of battery cells for a preset discharging time, and
the preset charging time is longer than the preset discharging time.

14. The battery diagnosis method of claim 10, wherein the measuring of the cell resistance comprises measuring the cell resistance of each of the plurality of battery cells by using a direct current internal resistance (DCIR) scheme.

15. The battery diagnosis method of claim 10, wherein the determining of the assembly state comprises determining, as being defective, an assembly state of a battery cell having a cell resistance greater than or equal to a preset resistance from among the plurality of battery cells.
